# EUROPEAN PATENT APPLICATION

(11) **EP 4 738 431 A1**
(43) Date of publication of application: **06.05.2026**
(21) Application number: 24831841.2
(22) Date of filing: 21.06.2024
(51) Int. Cl.: H01L 21/683, H01L 21/31, H01L 21/3065

(54) **ELECTROSTATIC CHUCK**

(30) Priority: 30.06.2023 JP 2023108894
(71) Applicant: Tomoegawa Corporation, Tokyo 104-8335 (JP)
(72) Inventor: MORIUCHI, Hideki, Shizuoka-shi, Shizuoka 421-0192 (JP)
(74) Representative: Hasegawa, Kan
(86) International application number: PCT/JP2024/022511
(87) International publication number: WO 2025/004980

(57) **Abstract**

An electrostatic chuck (1) includes: a substrate (2) for attracting an object to be attracted; a base (3) that supports the substrate (2); and an adhesive layer (4) that bonds the substrate (2) to the base (3). The adhesive layer (4) has a first adhesive layer (4a) positioned on the central side of the substrate (2), and a second adhesive layer (4b) positioned closer to an end of the substrate (2) than the first adhesive layer (4a). A plasma-protective layer (5) is provided closer to the end of the substrate (2) than the second adhesive layer (4b), and the plasma-protective layer (5) is bonded to the second adhesive layer (4b). The second adhesive layer (4b) has a Young's modulus at 100°C of 1 MPa or more, and a Young's modulus at 25°C of 1000 MPa or less.

## Description

### TECHNICAL FIELD

The present invention relates to an electrostatic chuck.

### BACKGROUND ART

Conventionally, etching apparatuses that perform plasma dry etching of wafers have been used as semiconductor manufacturing equipment. In such etching apparatuses, an electrostatic chuck is used to secure a planar material using static electricity. In such an electrostatic chuck, a substrate for attracting the planar material and a base that supports the substrate are bonded by an adhesive layer. To mitigate damage to the adhesive layer from plasma, a plasma-protective layer is bonded to the outer surface of the adhesive layer. International Patent Application Publication No. WO2016/132909 discloses an electrostatic chuck in which the plasma-protective layer is composed of an organic material such as fluorine or an acrylic resin.

### SUMMARY OF THE INVENTION

If there is a large difference in the coefficient of linear thermal expansion between the substrate for attracting a planar material and the base supporting the substrate, the substrate and the base will expand or contract respectively due to changes in the ambient temperature, and the resulting deformation of the adhesive layer can cause damage to the electrostatic chuck.

An object of the present invention is to provide an electrostatic chuck that can suppress such damage.

An electrostatic chuck of the present disclosure comprises:
a substrate for attracting an object to be attracted;
a base that supports the substrate; and
an adhesive layer that bonds the substrate to the base,

wherein the adhesive layer has a first adhesive layer positioned on a central side of the substrate, and a second adhesive layer positioned closer to an end of the substrate than the first adhesive layer,
wherein a plasma-protective layer is provided closer to the end of the substrate than the second adhesive layer, and the plasma-protective layer is bonded to the second adhesive layer, and
wherein the second adhesive layer has a Young's modulus at 100°C of 1 MPa or more, and a Young's modulus at 25°C of 1000 MPa or less.

In the electrostatic chuck of the present disclosure, the second adhesive layer may have a Young's modulus at 100°C of 10 MPa or more, and a Young's modulus at 25°C of 500 MPa or less.

In the electrostatic chuck of the present disclosure, the first adhesive layer may have a Young's modulus at 25°C in the range of 2000 MPa to 5000 MPa.

In the electrostatic chuck of the present disclosure, the plasma-protective layer may be disposed on a side closer to the center of the substrate than an end of the substrate.

In the electrostatic chuck of the present disclosure, the plasma-protective layer may be disposed at a distance in the range of 50 µm to 1000 µm from the end of the substrate toward the center of the substrate.

In the electrostatic chuck of the present disclosure, the second adhesive layer may have a shape recessed toward the central side of the substrate.

In the electrostatic chuck of the present disclosure, the first adhesive layer may contain a thermally conductive filler.

In the electrostatic chuck of the present disclosure, the plasma-protective layer may contain an inorganic material.

In the electrostatic chuck of the present disclosure, the inorganic material may be made of at least one of yttrium, aluminum, zirconium, calcium, and magnesium.

### BRIEF DESCRIPTION OF THE DRAWINGS

FIG. 1 is a cross-sectional view showing a schematic configuration of an electrostatic chuck according to an embodiment of the present disclosure.
FIG. 2 is a cross-sectional view showing a schematic configuration of another electrostatic chuck according to an embodiment of the present disclosure.

### DETAILED DESCRIPTION OF EMBODIMENTS

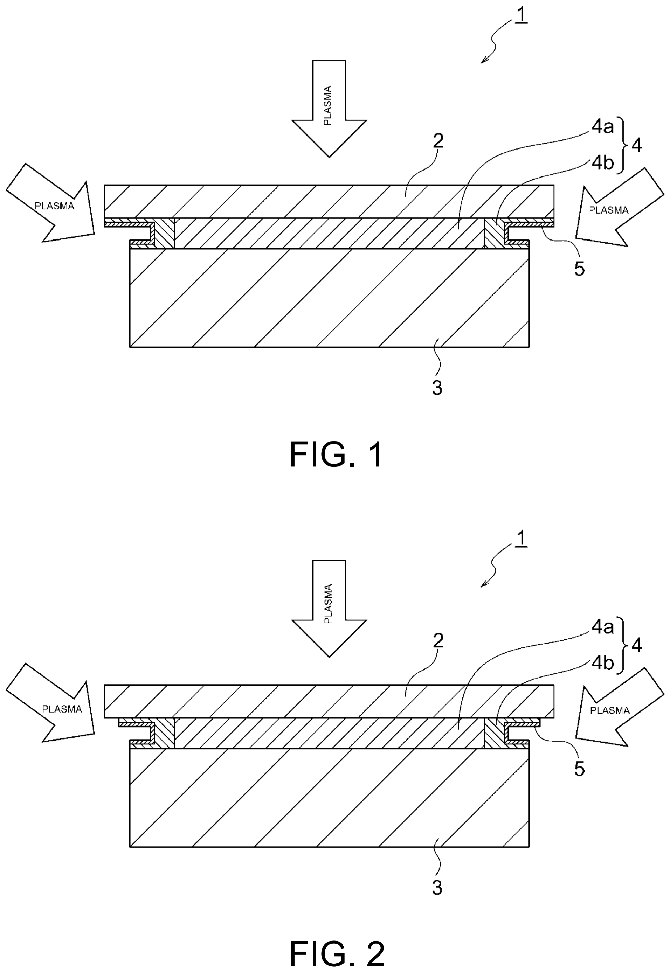

Hereinafter, embodiments of the present disclosure will be described with reference to the drawings. FIGS. 1 and 2 are cross-sectional views showing the schematic configurations of electrostatic chucks according to embodiments of the present disclosure.

### [Electrostatic chuck 1]

As shown in FIGS. 1 and 2, an electrostatic chuck 1 according to the present embodiment comprises a substrate 2 for attracting an object to be attracted, a base 3 that supports the substrate 2, and an adhesive layer 4 that bonds the substrate 2 to the base 3. The adhesive layer 4 has a first adhesive layer 4a positioned on the central side of the substrate 2, and a second adhesive layer 4b positioned closer to an end of the substrate 2 than the first adhesive layer 4a. Furthermore, the electrostatic chuck 1 comprises a plasma-protective layer 5 provided closer to the end of the substrate 2 than the second adhesive layer 4b, and the plasma-protective layer 5 is bonded to the second adhesive layer 4b.

### (Substrate 2)

The substrate 2 is for attracting and holding an object to be attracted (not shown). The shape of the substrate 2 is not limited, and may have a disk shape or a rectangular shape in accordance with the shape of the object to be attracted. The dimensions of the substrate 2 can also be set as appropriate in accordance with the object to be attracted. Note that the "object to be attracted" is also not limited, and can include various items such as wafers for manufacturing semiconductor devices, flat panel display (FPD) panels and substrates, metal members, film members, and glass members.

Examples of a material of the substrate 2 include a ceramic substrate, a silicon carbide substrate, and a metal substrate made of aluminum, stainless steel, or the like.

Also, the thickness of the substrate 2 is not particularly limited, and may be in a range of 0.2 mm to 7 mm. **In** a case where an internal electrode is provided to the substrate 2 as described later, the thickness of the substrate 2 may be in a range of 3 mm to 10 mm.

### (Base 3)

The base 3 supports the substrate 2 and also has a cooling function. The shape, material, thickness, and the like of the base 3 can be suitably designed or modified according to the application. For example, examples of the material for the base 3 include ceramic, metal, and combinations thereof.

### (Adhesive layer 4)

The adhesive layer 4 is for bonding the substrate 2 to the base 3. In the electrostatic chuck 1 according to the present embodiment, the adhesive layer 4 has a first adhesive layer 4a positioned on the central side of the substrate 2, and a second adhesive layer 4b positioned closer to an end of the substrate 2 than the first adhesive layer 4a (FIGS. 1 and 2).

The thickness of the adhesive layer 4 (the first adhesive layer 4a and the second adhesive layer 4b) is not particularly limited, but is preferably in the range of 50 µm to 500 µm, and more preferably in the range of 100 µm to 300 µm. If the thickness of the adhesive layer 4 is within this range, the adhesive layer 4 can suitably withstand stress caused by the difference in the coefficients of linear thermal expansion between the substrate and the base.

### (First adhesive layer 4a)

The Young's modulus of the first adhesive layer 4a at 25°C is preferably in the range of 2000 MPa to 5000 MPa, and more preferably in the range of 3000 MPa to 4000 MPa. If the Young's modulus of the first adhesive layer 4a at 25°C is within this range, the moderately rigid first adhesive layer 4a provides a sufficient adhesive force. This also accentuates the flexibility of the second adhesive layer 4b (described later), allowing the second adhesive layer 4b to effectively absorb stress from the expansion and contraction of the substrate 2 and the base 3, thereby suppressing cracking and peeling of the electrostatic chuck.

A resin can be used as the material for the first adhesive layer 4a. Examples of the resin include a thermoplastic elastomer, a thermosetting elastomer, an epoxy resin, a urethane resin, a polyester resin, a polyimide resin, a polyamide resin, a fluororubber, an acrylic rubber, a silicone rubber, and a urethane rubber.

The first adhesive layer 4a preferably contains a thermally conductive filler. By including the thermally conductive filler, both adhesiveness and thermal conductivity can be achieved. Examples of the thermally conductive filler include, but are not limited to, alumina, aluminum nitride, silicon carbide, boron nitride, carbon black, and carbon nanotubes. The amount, shape, and the like of the thermally conductive filler are also not particularly limited.

### (Second adhesive layer 4b)

The Young's modulus of the second adhesive layer 4b at 100°C is 1 MPa or more, and its Young's modulus at 25°C is 1000 MPa or less. Because the Young's modulus at 100°C is 1 MPa or more, the second adhesive layer 4b has an appropriate fluidity, which suppresses deformation and cracking of the plasma-protective layer 5 caused by excessively high fluidity. On the other hand, because the Young's modulus at 25°C is 1000 MPa or less, deformation and cracking of the electrostatic chuck can be suppressed when a difference arises in the coefficients of linear thermal expansion between the substrate 2 and the base 3.

For example, the upper limit of the Young's modulus of the second adhesive layer 4b at 100°C is 100 MPa or less, and the lower limit of its Young's modulus at 25°C is 10 MPa or more. Preferably, the Young's modulus of the second adhesive layer 4b at 100°C is 10 MPa or more, and its Young's modulus at 25°C is 500 MPa or less. Such a second adhesive layer 4b can be expected to more reliably suppress cracking of the electrostatic chuck caused by the difference in the coefficients of linear thermal expansion with the substrate 2 and the base 3.

Examples of suitable materials for the second adhesive layer 4b include a thermoplastic elastomer, a thermosetting elastomer, an epoxy resin, a urethane resin, a polyester resin, a polyimide resin, a polyamide resin, a fluororubber, an acrylic rubber, a silicone rubber, and a urethane rubber. Furthermore, a thermally conductive filler may be used in combination in the second adhesive layer 4b, as appropriate. Examples of the thermally conductive filler include alumina, aluminum nitride, silicon carbide, boron nitride, carbon black, and carbon nanotubes.

The method for measuring the Young's modulus is not particularly limited, and dynamic mechanical analysis can be used. For example, using a RHEOVIBRON DDV-II (manufactured by Orientec Co., Ltd.) as the measurement apparatus, the Young's modulus can be measured at 25°C and 100°C under set conditions of a vibration frequency of 11 Hz and a heating rate of 5°C/minute.

The volume ratio between the first adhesive layer 4a and the second adhesive layer 4b in the horizontal direction is not limited to that shown in FIGS. 1 and 2, and can be appropriately designed such that while the substrate 2 and the base 3 are bonded by the first adhesive layer 4a, stress from the expansion and contraction of the substrate 2 or the base 3 is absorbed by the second adhesive layer 4b. As an example, the ratio of the volume of the second adhesive layer 4b to the volume of the first adhesive layer 4a is 0.01% by volume or more and 20% by volume or less, and is preferably 1% by volume or more and 10% by volume or less. Note that the first adhesive layer 4a and the second adhesive layer 4b are not necessarily required to be formed concentrically. Furthermore, the length of the adhesive layer 4 (the total length of the first adhesive layer 4a and the second adhesive layer 4b) in the horizontal direction can also be appropriately designed.

The second adhesive layer 4b can be formed in a shape recessed toward the central side of the substrate 2. In FIGS. 1 and 2, the second adhesive layer 4b (and also the plasma-protective layer 5 described later) is recessed in an angular shape, but may be formed in an arc shape.

### (Plasma-protective layer 5)

The plasma-protective layer 5 is bonded to the second adhesive layer 4b and protects the adhesive layer 4 from plasma. The material of the plasma-protective layer 5 can include an inorganic material. Examples of the inorganic material include a material containing at least one of yttrium, aluminum, zirconium, calcium, and magnesium. This inorganic material may be an oxide or hydroxide of these elements, or a mixture thereof, and the mixture may contain hydroxyapatite.

In the electrostatic chuck 1, the plasma-protective layer 5 may be disposed on a side closer to the center of the substrate 2 than an end of the substrate 2 (FIG. 2). Specifically, the plasma-protective layer 5 may be disposed at a distance in the range of 50 µm to 1000 µm from the end of the substrate 2 toward the center of the substrate 2. For example, if the plasma-protective layer 5 is disposed at a distance of 1000 µm from the end (start point: 0 µm) of the substrate 2 as shown in FIG. 2, deterioration of the plasma-protective layer 5 due to plasma or the like can be suppressed, and the adhesive layer 4 is also disposed farther from a plasma source and can therefore be more reliably protected. In this case, the length of the substrate 2 in the horizontal direction can be in the range of 30 mm to 600 mm.

Furthermore, the thickness of the plasma-protective layer 5 is not particularly limited, but can be in the range of 1 µm to 300 µm, and is preferably in the range of 20 µm to 150 µm. With such a plasma-protective layer 5, cracking and peeling of the plasma-protective layer 5 itself can be suppressed while the adhesive layer 4 is protected from plasma.

### (Others)

In the electrostatic chuck 1 according to the present embodiment, an internal electrode (not shown) can be provided on the substrate 2 in order to generate an electrostatic force (Coulomb force) by applying a voltage, thereby attracting an object to be attracted. Alternatively, such an internal electrode may be provided on the base 3.

The internal electrode is not particularly limited as long as it is made of an electrically conductive substance that can generate an electrostatic attractive force when a voltage is applied. As the internal electrode, for example, a thin film made of a metal such as copper, aluminum, gold, silver, platinum, chromium, nickel, or tungsten, or a thin film made of at least two kinds of metals selected from the aforementioned metals, is suitably used. Examples of such a metal thin film include a film formed by vapor deposition, plating, sputtering, or the like; a film formed by applying and drying an electrically conductive paste; and specifically, a metal foil such as a copper foil.

### (Manufacturing Method and Use of Electrostatic Chuck 1)

The electrostatic chuck 1 can be manufactured as follows, for example. First, the substrate 2 and the base 3 are prepared. At this time, as described above, an internal electrode is formed by forming a pattern of a metal such as copper on either the substrate 2 or the base 3. Next, the substrate 2 and the base 3 are bonded to each other via the adhesive layer 4 (in this state, the first adhesive layer 4a). At this time, the formation range of the first adhesive layer 4a is determined so that a gap is formed at a predetermined distance from the respective ends of the substrate 2 and the base 3. The second adhesive layer 4b and the plasma-protective layer 5 are to be formed in this gap. Next, the plasma-protective layer 5 is formed so as to close the gap. Next, using surface tension, a coating liquid that will become the second adhesive layer 4b is injected into the space between the substrate 2, the base 3, the first adhesive layer 4a, and the plasma-protective layer 5. Thereafter, the portions of the second adhesive layer 4b and the plasma-protective layer 5 protruding from the end of the substrate 2 are removed by grinding, whereby the electrostatic chuck 1 as shown in FIG. 1 or FIG. 2 can be obtained. The electrostatic chuck 1 can also be manufactured by the manufacturing method of the Examples described later.

The electrostatic chuck 1 according to the present embodiment generates a Coulomb force by applying a voltage to an internal electrode embedded in the substrate 2 or the base 3, thereby attracting an object to be attracted. For example, in a dry etching or CVD process in a semiconductor manufacturing process, the electrostatic chuck 1 can be used to attract a wafer (an object to be attracted). In particular, in an apparatus or method that uses plasma, with the electrostatic chuck 1 according to the present embodiment, the adhesive layer 4 can be protected from plasma by the plasma-protective layer 5. At the same time, even if the substrate 2 or the base 3 becomes hot and expands due to plasma irradiation, the second adhesive layer 4b can follow this thermal expansion. Therefore, cracking of the electrostatic chuck caused by the difference in the coefficients of linear thermal expansion with the substrate 2 and the base 3 can also be suppressed. As a result, the lifetime and productivity of the electrostatic chuck 1 itself are improved as compared to a conventional electrostatic chuck.

The electrostatic chuck 1 according to the present embodiment, configured as described above, comprises: the substrate 2 for attracting an object to be attracted; the base that supports the substrate 2; and the adhesive layer 4 that bonds the substrate 2 to the base 3. The adhesive layer 4 has the first adhesive layer 4a positioned on the central side of the substrate 2, and the second adhesive layer 4b positioned closer to an end of the substrate 2 than the first adhesive layer 4a. The plasma-protective layer 5 is provided closer to the end of the substrate 2 than the second adhesive layer 4b, and the plasma-protective layer 5 is bonded to the second adhesive layer 4b. The second adhesive layer 4b has a Young's modulus at 100°C of 1 MPa or more, and a Young's modulus at 25°C of 1000 MPa or less. Thus, because the second adhesive layer 4b has an appropriate fluidity, deformation and cracking of the electrostatic chuck due to excessively high fluidity can be suppressed. Furthermore, even if the substrate 2 or the base 3 expands or contracts due to a change in the ambient temperature caused by plasma etching or the like, the second adhesive layer 4b absorbs the stress from the expansion and contraction, thereby suppressing deformation and cracking of the electrostatic chuck caused by the difference in the coefficients of linear thermal expansion with the substrate 2 and the base 3.

Furthermore, in the electrostatic chuck 1 according to the present embodiment, the second adhesive layer 4b may have a Young's modulus at 100°C of 10 MPa or more, and a Young's modulus at 25°C of 500 MPa or less. With such a second adhesive layer 4b, it can be expected that cracking of the electrostatic chuck caused by the difference in the coefficients of linear thermal expansion with the substrate 2 and the base 3 can be more reliably suppressed.

Furthermore, in the electrostatic chuck 1 according to the present embodiment, the first adhesive layer 4a may have a Young's modulus at 25°C in the range of 2000 MPa to 5000 MPa. Thus, a sufficient adhesive force is provided by the moderately rigid first adhesive layer 4a. In addition, the second adhesive layer 4b, which is softer than the first adhesive layer 4a, more effectively absorbs stress from the expansion and contraction of the substrate 2 or the base 3, thereby making it possible to even more reliably suppress cracking and peeling of the electrostatic chuck.

Furthermore, in the electrostatic chuck 1 according to the present embodiment, the plasma-protective layer 5 may be disposed on a side closer to the center of the substrate 2 than an end of the substrate 2. In addition, the plasma-protective layer 5 may be disposed at a distance in the range of 50 µm to 1000 µm from the end of the substrate 2 toward the center of the substrate 2 (FIG. 2). Thus, because the plasma-protective layer 5 does not protrude outward from the end of the substrate 2, deterioration of the plasma-protective layer 5 due to plasma or the like can be suppressed, and the adhesive layer 4 is less likely to be exposed to plasma and is thus more reliably protected.

Furthermore, in the electrostatic chuck 1 according to the present embodiment, the second adhesive layer 4b may have a shape recessed toward the central side of the substrate 2. In this way, the second adhesive layer 4b can be shielded from plasma heat.

Furthermore, in the electrostatic chuck 1 according to the present embodiment, the first adhesive layer 4a may contain a thermally conductive filler. **In** this way, variations in the thickness and temperature distribution within the first adhesive layer 4a can be suppressed, and heat from the surrounding environment can be dissipated.

Furthermore, in the electrostatic chuck 1 according to the present embodiment, the plasma-protective layer 5 may include an inorganic material. **In** addition, this inorganic material may be composed of at least one of yttrium, aluminum, zirconium, calcium, and magnesium. Such a material can provide suitable plasma resistance.

The electrostatic chuck 1 according to the present embodiment is not limited to the configurations and combinations described above.

For example, the number of internal electrodes provided on the substrate 2 or the base 3 is not limited to one and may be two.

Furthermore, although the plasma-protective layer 5 is provided on the end side of the substrate 2, it is not limited to only a portion of the end; the plasma-protective layer 5 may be provided along the entire outer periphery of the substrate 2. It is also possible to provide the plasma-protective layers 5 (the second adhesive layers 4b) so as to be bilaterally symmetric in the peripheral region of the substrate 2 (e.g., at four locations).

Hereinafter, the present disclosure will be described in more detail using Examples and Comparative Examples.

### <Example 1>

An evaluation sample was manufactured using the materials shown in Table 1. Specifically, an alumina substrate (300 mmφ disk, 3.0 mm thick) and an aluminum base (295 mmφ disk, 15 mm thick) were prepared. A silicone-based adhesive was applied concentrically to the substrate such that an uncoated portion with a width of 4.0 mm was formed along the entire outer periphery from the end of the substrate toward the center, and the substrate was bonded to the base. The thickness of the silicone-based adhesive was 150 µm. Next, a polyimide-based adhesive was applied to the entire outer periphery of the silicone-based adhesive, and then left to stand for 10 minutes in a thermostatic chamber set at 120°C to dry the polyimide-based adhesive. The thickness of the polyimide-based adhesive after drying was 150 µm. Thereafter, using a plasma spray apparatus, alumina particles were sprayed onto the entire outer periphery of the polyimide-based adhesive such that a plasma-protective layer with a thickness of 75 µm was formed at the position shown in Table 1 (substrate end: 0 µm). The polyimide-based adhesive and the plasma-protective layer protruding from the outer peripheries of the substrate and the base were polished using an electric rotary tool to obtain an evaluation sample.

The silicone-based adhesive and the polyimide-based adhesive used in each Example were produced as follows.

An aluminum nitride filler ("AIN filler FAN-f05" manufactured by Furukawa Denshi Co., Ltd., average particle size: 3 to 10 µm) was mixed and stirred with a commercial silicone adhesive ("KE-8101", a one-component addition-cure RTV silicone rubber manufactured by Shin-Etsu Chemical Co., Ltd.) at blend ratios (blend amounts with respect to 100 parts by weight of the silicone adhesive) shown in Tables 1 to 4, thus obtaining silicone-based adhesives that exhibited the Young's moduli shown in Tables 1 to 4.

A commercial polyimide adhesive ("solvent-soluble thermoplastic polyimide PI-1" manufactured by T&K TOKA Co., Ltd.) was dissolved in tetrahydrofuran, thus preparing a 25% solution. Thereafter, an alumina filler ("TAIMICRON TM-UF" manufactured by TAIMEI CHEMICALS Co., Ltd., average particle size: 0.09 µm) was mixed and stirred with the solution at blend ratios (blend amounts with respect to 100 parts by weight of the polyimide adhesive) shown in Tables 1 to 4, thus obtaining polyimide-based adhesives that exhibited Young's moduli shown in Tables 1 to 4.

### <Examples 2 to 5, 8, 9, and 11 to 23>

As shown in Tables 1 to 4, evaluation samples were obtained in the same manner as in Example 1.

### <Example 6>

An evaluation sample was obtained in the same manner as in Example 1, except that the silicone-based adhesive was applied concentrically to the substrate so that an uncoated portion with a width of 2.0 mm was formed along the entire outer periphery from the end of the substrate toward the center.

### <Example 7>

An evaluation sample was obtained in the same manner as in Example 1, except that the silicone-based adhesive was applied concentrically to the substrate so that an uncoated portion with a width of 7.5 mm was formed along the entire outer periphery from the end of the substrate toward the center.

### <Example 10>

An evaluation sample was obtained in the same manner as in Example 1, except for the method of forming the plasma-protective layer. Specifically, a 20% by mass solution of aluminum nitrate nonahydrate in 1,3-butanediol was prepared and applied to the entire outer periphery of the polyimide-based adhesive by a spray method. Thereafter, it was placed in a thermostatic chamber set at 200°C and dried for two hours to form a plasma-protective layer. The polyimide-based adhesive and the plasma-protective layer protruding from the outer peripheries of the substrate and the base were polished using an electric rotary tool to obtain an evaluation sample.

### <Comparative Examples 1 and 2>

As shown in Table 4, evaluation samples were obtained in the same manner as in Example 1. In Comparative Examples 1 and 2, a thermoplastic (TPE) adhesive was used instead of the polyimide-based adhesive. That is, a styrenic thermoplastic elastomer (TPE) (Kraton G1651 manufactured by Kraton Corporation) was dissolved in toluene, thus preparing a 25% solution. Thereafter, an alumina filler ("TAIMICRON TM-UF" manufactured by TAIMEI CHEMICALS Co., Ltd., average particle size: 0.09 µm) was mixed and stirred with the solution at blend ratios (blend amounts with respect to 100 parts by weight of the solution) shown in Table 4, thus obtaining TPE-based adhesives that exhibited Young's moduli shown in Table 4.

### <Evaluation>

### (Evaluation for plasma resistance)

Evaluation for plasma resistance in Examples 1 to 23 and Comparative Examples 1 and 2 was conducted. That is, each evaluation sample was placed at a parallel flat plate type RIE apparatus. Thereafter, in a vacuum (not higher than 20 Pa) and with a high-frequency power supply (output: 250 W), oxygen gas (10 sccm) and carbon tetrafluoride gas (40 sccm) were introduced, and change in the surface state of the outer circumference of each evaluation sample after exposure for twenty-four hours was visually observed. Then, the sample of which the plasma-protective layer remained without damage over the entire outer circumference was evaluated as "Excellent", the sample of which the plasma-protective layer was partially cracked but the plasma-protective layer remained over the entire outer circumference was evaluated as "Good", and the sample of which the plasma-protective layer had cracking and peeling and was partially lost was evaluated as "Poor".

### (Evaluation of Cracking and Peeling: Heat Cycle Resistance)

The evaluation of cracking and peeling of each evaluation sample of Examples 1 to 23 and Comparative Examples 1 and 2 after thermal cycles was conducted. Specifically, each evaluation sample was placed in a thermostatic chamber (TCC-151W, manufactured by ESPEC CORP.) set to 0°C. Thereafter, a cycle of raising the temperature to 120°C at a heating rate of 50°C/hour and then immediately lowering the temperature to 0°C at a cooling rate of 50°C/hour was repeated for 200 cycles. After the 200 cycles were completed, each evaluation sample was removed from the thermostatic chamber, and the appearance (the plasma-protective layer, the substrate, and the base) of each evaluation sample was observed. The samples were rated as follows: a sample in which no cracking or peeling occurred at all was rated "Excellent"; a sample in which only cracking of the plasma-protective layer occurred was rated as "Good"; a sample in which peeling occurred on a part of the plasma-protective layer was rated as "Fair"; and a sample in which cracking or peeling of the substrate or the base occurred was rated as "Poor".

### (Total evaluation)

Of the evaluation for plasma resistance and the for cracking and peeling, a case where two evaluations were "Excellent" was evaluated as "Extremely excellent", and a case where one evaluation was "Good" or "Fair" and the other evaluation was "Excellent" was evaluated as "Excellent". A case where two evaluations were "Good" and a case where one evaluation was "Good" and the other evaluation was "Fair" were evaluated as "Good". A case where two evaluations were "Fair" was evaluated as "Fair". A case where at least one of the evaluations was "Poor" was evaluated as "Poor".

**[Table 1]**

| | | Example 1 | Example 2 | Example 3 | Example 4 | Example 5 | Example 6 |
|---|---|---|---|---|---|---|---|
| First adhesive layer | Thickness (µm) | 150 | 150 | 150 | 60 | 350 | 150 |
| | Young's modulus (MPa) at 25°C | 3670 | 3670 | 3670 | 3670 | 3670 | 3670 |
| | AIN thermally conductive filler (blend ratio) | 600 | 600 | 600 | 600 | 600 | 600 |
| Second adhesive layer | Material | Polyimide | Polyimide | Polyimide | Polyimide | Polyimide | Polyimide |
| | Young's modulus (MPa) at 25°C | 360 | 134 | 480 | 360 | 360 | 360 |
| | Young's modulus (MPa) at 100°C | 25 | 10 | 12 | 25 | 25 | 25 |
| | Alumina thermally conductive filler (blend ratio) | 100 | 52 | 130 | 100 | 100 | 100 |
| Volume ratio (second adhesive layer/first adhesive layer) (vol%) | | 5 | 5 | 5 | 5 | 5 | 2 |
| Plasma-protective layer | Material | Alumina | Alumina | Alumina | Alumina | Alumina | Alumina |
| | Thickness (µm) | 75 | 75 | 75 | 75 | 75 | 75 |
| | Position (µm) | 52 | 52 | 52 | 52 | 52 | 52 |
| Substrate | Material | Alumina | Alumina | Alumina | Alumina | Alumina | Alumina |
| Base | Material | Aluminum | Aluminum | Aluminum | Aluminum | Aluminum | Aluminum |
| Evaluation | Plasma resistance (Excellent, Good, Poor) | Excellent | Excellent | Excellent | Excellent | Excellent | Excellent |
| | Crack and separation (Excellent, Good, Fair, Poor) | Excellent | Excellent | Excellent | Excellent | Excellent | Excellent |
| | Total evaluation (Extremely excellent, Excellent, Good, Fair, Poor) | Extremely excellent | Extremely excellent | Extremely excellent | Extremely excellent | Extremely excellent | Extremely excellent |

**[Table 2]**

| | | Example 7 | Example 8 | Example 9 | Example 10 | Example 11 | Example 12 |
|---|---|---|---|---|---|---|---|
| First adhesive layer | Thickness (µm) | 150 | 150 | 150 | 150 | 150 | 150 |
| | Young's modulus (MPa) at 25°C | 3670 | 3670 | 3670 | 3670 | 3670 | 3670 |
| | AIN thermally conductive filler (blend ratio) | 600 | 600 | 600 | 600 | 600 | 600 |
| Second adhesive layer | Material | Polyimide | Polyimide | Polyimide | Polyimide | Polyimide | Polyimide |
| | Young's modulus (MPa) at 25°C | 360 | 332 | 343 | 360 | 360 | 360 |
| | Young's modulus (MPa) at 100°C | 25 | 23 | 22 | 25 | 25 | 25 |
| | Alumina thermally conductive filler (blend ratio) | 100 | 95 | 87 | 100 | 100 | 100 |
| Volume ratio (second adhesive layer/first adhesive layer) (vol%) | | 10 | 5 | 5 | 5 | 5 | 5 |
| Plasma-protective layer | Material | Alumina | Alumina | Alumina | Alumina | Alumina | Alumina |
| | Thickness (µm) | 75 | 75 | 75 | 0.7 | 350 | 75 |
| | Position (µm) | 52 | 980 | 41 | 52 | 52 | 1100 |
| Substrate | Material | Alumina | Alumina | Alumina | Alumina | Alumina | Alumina |
| Base | Material | Aluminum | Aluminum | Aluminum | Aluminum | Aluminum | Aluminum |
| Evaluation | Plasma resistance (Excellent, Good, Poor) | Excellent | Excellent | Good | Good | Excellent | Excellent |
| | Crack and separation (Excellent, Good, Fair, Poor) | Excellent | Excellent | Excellent | Excellent | Good | Good |
| | Total evaluation (Extremely excellent, Excellent, Good, Fair, Poor) | Extremely excellent | Extremely excellent | Excellent | Excellent | Excellent | Excellent |

**[Table 3]**

| | | Example 13 | Example 14 | Example 15 | Example 16 | Example 17 | Example 18 |
|---|---|---|---|---|---|---|---|
| First adhesive layer | Thickness (µm) | 150 | 150 | 150 | 150 | 150 | 150 |
| | Young's modulus (MPa) at 25°C | 2120 | 4760 | 3120 | 3900 | 1820 | 5260 |
| | AIN thermally conductive filler (blend ratio) | 400 | 900 | 550 | 630 | 330 | 950 |
| Second adhesive layer | Material | Polyimide | Polyimide | Polyimide | Polyimide | Polyimide | Polyimide |
| | Young's modulus (MPa) at 25°C | 371 | 363 | 363 | 363 | 360 | 360 |
| | Young's modulus (MPa) at 100°C | 24 | 25 | 25 | 25 | 25 | 25 |
| | Alumina thermally conductive filler (blend ratio) | 110 | 100 | 100 | 100 | 100 | 100 |
| Volume ratio (second adhesive layer/first adhesive layer) (vol%) | | 5 | 5 | 5 | 5 | 5 | 5 |
| Plasma-protective layer | Material | Alumina | Alumina | Alumina | Alumina | Alumina | Alumina |
| | Thickness (µm) | 75 | 75 | 75 | 75 | 75 | 75 |
| | Position (µm) | 52 | 52 | 52 | 52 | 52 | 52 |
| Substrate | Material | Alumina | Alumina | Alumina | Alumina | Alumina | Alumina |
| Base | Material | Aluminum | Aluminum | Aluminum | Aluminum | Aluminum | Aluminum |
| Evaluation | Plasma resistance (Excellent, Good, Poor) | Excellent | Excellent | Excellent | Excellent | Good | Good |
| | Crack and separation (Excellent, Good, Fair, Poor) | Good | Good | Excellent | Excellent | Fair | Fair |
| | Total evaluation (Extremely excellent, Excellent, Good, Fair, Poor) | Excellent | Excellent | Extremely excellent | Extremely excellent | Good | Good |

**[Table 4]**

| | | Example 19 | Example 20 | Example 21 | Example 22 | Example 23 | Comparative Example 1 | Comparative Example 2 |
|---|---|---|---|---|---|---|---|---|
| First adhesive layer | Thickness (µm) | 150 | 150 | 150 | 150 | 150 | 150 | 150 |
| | Young's modulus (MPa) at 25°C | 3670 | 3670 | 3670 | 3670 | 3670 | 3670 | 3670 |
| | AIN thermally conductive filler (blend ratio) | 600 | 600 | 600 | 600 | 600 | 600 | 600 |
| Second adhesive layer | Material | Polyimide | Polyimide | Polyimide | Polyimide | Polyimide | TPE | TPE |
| | Young's modulus (MPa) at 25°C | 990 | 12 | 76 | 730 | 173 | 1215 | 360 |
| | Young's modulus (MPa) at 100°C | 97 | 1 | 4 | 59 | 9 | 101 | 0.5 |
| | Alumina thermally conductive filler (blend ratio) | 300 | 0 | 20 | 180 | 40 | 110 | 35 |
| Volume ratio (second adhesive layer/first adhesive layer) (vol%) | | 5 | 5 | 5 | 5 | 5 | 5 | 5 |
| Plasma-protective layer | Material | Alumina | Alumina | Alumina | Alumina | Alumina | Alumina | Alumina |
| | Thickness (µm) | 75 | 75 | 75 | 75 | 75 | 75 | 75 |
| | Position (µm) | 52 | 52 | 52 | 52 | 52 | 52 | 52 |
| Substrate | Material | Alumina | Alumina | Alumina | Alumina | Alumina | Alumina | Alumina |
| Base | Material | Aluminum | Aluminum | Aluminum | Aluminum | Aluminum | Aluminum | Aluminum |
| Evaluation | Plasma resistance (Excellent, Good, Poor) | Good | Good | Good | Good | Good | Good | Good |
| | Crack and separation (Excellent, Good, Fair, Poor) | Fair | Fair | Fair | Fair | Fair | Poor | Poor |
| | Total evaluation (Extremely excellent, Excellent, Good, Fair, Poor) | Good | Good | Good | Good | Good | Poor | Poor |

As shown in Tables 1-4, in the evaluation samples (Comparative Examples 1 and 2) having a second adhesive layer with a Young's modulus at 100°C of less than 1 MPa or a Young's modulus at 25°C of greater than 1000 MPa, cracking or peeling occurred on the plasma-protective layer, the substrate, and the base (thermal cycle test). In contrast, the evaluation samples (Examples) according to the present disclosure, which have a second adhesive layer with a Young's modulus at 100°C of 1 MPa or more and a Young's modulus at 25°C of 1000 MPa or less, not only exhibited plasma resistance but also had higher heat cycle resistance, and were able to suppress the peeling of the plasma-protective layer, the substrate, and the base. That is, compared to the Comparative Examples, the electrostatic chuck according to the present disclosure was able to suppress damage to the electrostatic chuck caused by the difference in the coefficients of thermal expansion with the substrate and the base.

Furthermore, a comparison between Examples 13-16 and Examples 17-18 shows that the plasma resistance and heat cycle resistance were even better when the Young's modulus (at 25°C) of the first adhesive layer was in the range of 2000 MPa to 5000 MPa. The plasma resistance and heat cycle resistance were particularly good when the Young's modulus (at 25°C) of the first adhesive layer was in the range of 3000 MPa to 4000 MPa.

Furthermore, a comparison between Examples 1-8 and Examples 9 and 12 shows that the plasma resistance and heat cycle resistance were both good even when the plasma-protective layer was disposed at a distance in the range of 50 µm to 1000 µm from the end of the substrate toward the center of the substrate.

Furthermore, for example, a comparison between Example 1 and Examples 10 and 11 shows that plasma resistance and heat cycle resistance can be exhibited in a well-balanced manner when the thickness of the plasma-protective layer 5 is in the range of 1 µm to 300 µm.

## Claims

1. An electrostatic chuck, comprising:
a substrate for attracting an object to be attracted;
a base for supporting the substrate; and
an adhesive layer for bonding the substrate to the base,
wherein the adhesive layer has a first adhesive layer positioned on a central side of the substrate, and a second adhesive layer positioned closer to an end of the substrate than the first adhesive layer;
wherein a plasma-protective layer is provided closer to the end of the substrate than the second adhesive layer, and the plasma-protective layer is bonded to the second adhesive layer; and
wherein the second adhesive layer has a Young's modulus at 100°C of 1 MPa or more, and a Young's modulus at 25°C of 1000 MPa or less.

2. The electrostatic chuck according to claim 1, wherein
the second adhesive layer has a Young's modulus at 100°C of 10 MPa or more, and a Young's modulus at 25°C of 500 MPa or less.

3. The electrostatic chuck according to claim 1, wherein
the first adhesive layer has a Young's modulus at 25°C in the range of 2000 MPa to 5000 MPa.

4. The electrostatic chuck according to claim 1, wherein
the plasma-protective layer is disposed on a side closer to the center of the substrate than an end of the substrate.

5. The electrostatic chuck according to claim 4, wherein
the plasma-protective layer is disposed at a distance in the range of 50 µm to 1000 µm from the end of the substrate toward the center of the substrate.

6. The electrostatic chuck according to claim 1, wherein
the second adhesive layer has a shape recessed toward the central side of the substrate.

7. The electrostatic chuck according to claim 1, wherein
the first adhesive layer contains a thermally conductive filler.

8. The electrostatic chuck according to any one of claims 1 to 7, wherein
the plasma-protective layer contains an inorganic material.

9. The electrostatic chuck according to claim 8, wherein
the inorganic material is made of at least one of yttrium, aluminum, zirconium, calcium, and magnesium.
